# FASCICULE DE BREVET EUROPEEN

(11) **EP 2 959 034 B1**
(45) Date de publication et mention de la délivrance du brevet: **12.09.2018**
(21) Numéro de dépôt: 14706038.8
(22) Date de dépôt: 21.02.2014
(51) Int. Cl.: C23C 16/44, C23C 16/455

(54) **DISPOSITIF DE DÉPÔT CHIMIQUE EN PHASE VAPEUR**
CVD-VORRICHTUNG
CHEMICAL VAPOR DEPOSITION DEVICE

(30) Priorité: 21.02.2013 FR 1351525
(43) Date de publication de la demande: 30.12.2015
(73) Titulaire: Kobus SAS, 38330 Montbonnot-Saint-Martin (FR)
(72) Inventeur: NAL, Patrice, F-38000 Grenoble (FR); BOREAN, Christophe, F-38660 Le Touvet (FR); VITIELLO, Julien, F-38100 Grenoble (FR)
(74) Mandataire: IP Trust
(86) Numéro de dépôt international: PCT/EP2014/053463
(87) Numéro de publication internationale: WO 2014/128269

(56) Documents cités:
- DE-A1- 4 417 626
- US-A- 6 045 862
- US-A- 6 159 299
- US-A1- 2005 170 090

## Description

### DOMAINE DE L'INVENTION

L'invention relève du domaine de la fabrication de circuits intégrés ou de microsystèmes, et plus particulièrement des équipements et procédés de dépôt chimique en phase vapeur. Ces derniers sont aussi désignés dans la technique équipement et procédés "CVD", ou "Chemical Vapor Déposition", terme équivalent en anglais.

### ARRIERE-PLAN DE L'INVENTION

Les circuits intégrés et les microsystèmes sont fabriqués à partir de plaquettes, ou substrats, en silicium ou autre matériau semi-conducteur, qui subissent une succession d'étapes de dépôt de couches minces de divers matériaux, de masquage et de lithographie de ces couches, puis de gravure de ces mêmes couches. Entre ces étapes de fabrication viennent s'intercaler des étapes de nettoyage des équipements ainsi que des étapes d'inspection de la qualité des produits.

Dans les dépôts chimiques, une adsorption, une chimisorption ou une réaction hétérogène se produit à la surface du substrat à recouvrir. Dans le cas d'un dépôt en phase vapeur, cette réaction se produit sur toutes les surfaces où les conditions de température, de pression et de concentration des réactifs se trouvent réunies. Il en résulte que les dépôts chimiques recouvrent uniformément la surface de motifs formés sur les substrats, même celles sensiblement verticales. Cette caractéristique est particulièrement utile dans la fabrication des circuits et des microsystèmes récents où les motifs à recouvrir peuvent présenter des facteurs de forme (rapport entre la largeur et la hauteur du motif) très élevés.

Les équipements CVD comprennent généralement une chambre de traitement dans laquelle sont logés un support de substrat et un ensemble de distribution de gaz, également connu sous le terme de douche, ou "showerhead" en langue anglaise. Ce dernier délivre des agents chimiques sous forme gazeuse, appelés également gaz de traitement, ou précurseurs, à proximité du substrat. Le support présente une face supérieure adaptée pour maintenir les substrats et une face inférieure, opposée à sa face supérieure. Le support de substrat partage l'espace intérieur de la chambre de traitement en un espace supérieur et un espace inférieur. L'espace supérieur se trouve du côté de la face supérieure du support et est délimité par des parois de la chambre de traitement. L'espace inférieur se trouve du côté de la face inférieure du support et est délimité par des parois de la chambre de traitement.

Un gaz de purge est injecté dans l'espace inférieur de la chambre de traitement pour limiter la contamination des parois de la chambre par les agents chimiques injectés par la douche dans l'espace supérieur de la chambre. (voir par exemple le document US2005/0170090 A1) Malgré ces dispositions, des réactions parasites conduisant à des dépôts non souhaités subsistent, notamment dans l'espace de la chambre situé sous le support. La contamination particulaire des équipements qui en découle nuit à leur efficacité. Les contaminations imposent de nettoyer fréquemment la chambre de traitement ce qui affecte sa disponibilité. Un but de l'invention est de proposer un dispositif de réacteur dans lequel la contamination par des dépôts parasites est limitée afin d'améliorer la disponibilité.

Ces dépôts parasites sont d'autant plus importants que la température est élevée. Or, le support pour les substrats est chauffé pour que les substrats atteignent la température nécessaire aux réactions désirées. Afin de limiter les phénomènes de condensation des gaz réactifs au contact du système de distribution, celui-ci est chauffé. Le reste des dispositifs a donc tendance à être chauffé également.

Dans des conditions dites de haute température, typiquement comprise entre 600 et 800°C, ces dépôts obligent à des nettoyages encore plus fréquents et une maintenance qui rendent les appareils pratiquement inutilisables industriellement dans ces domaines.

### BREVE DESCRIPTION DE L'INVENTION

L'invention vient améliorer la situation.

A cet effet, il est proposé un dispositif de réacteur pour dépôt chimique en phase vapeur comprenant :
- une chambre de réaction présentant une paroi intérieure latérale ;
- un injecteur de gaz réactif débouchant dans la chambre de réaction ;
- un support de substrat présentant :
   - une face principale destinée à supporter au moins un substrat, agencée en regard de l'injecteur de gaz réactif de sorte que ledit injecteur et ladite face principale (5a) définissent entre eux un espace de travail, et
   - une surface périphérique en regard de la paroi latérale de la chambre de réaction,
- un système d'évacuation des gaz en liaison fluidique avec la chambre de réaction par une ouverture agencée dans la paroi latérale de la chambre de réaction en regard de l'espace de travail,
   le support de substrat étant disposé dans la chambre de réaction de manière à former un passage annulaire entre la surface périphérique du support de substrat et la paroi latérale de la chambre de réaction ;
- un injecteur de gaz de purge débouchant dans la chambre de réaction.

Conformément à l'invention, l'injecteur de gaz de purge comprend un canal d'injection délimité par la paroi latérale de la chambre et une première paroi d'une pièce additionnelle, ledit canal débouchant dans la chambre de réaction par une embouchure annulaire, la paroi latérale de la chambre de réaction et la première paroi de la pièce additionnelle étant parallèles dans une portion dudit canal d'injection comprenant l'embouchure, de sorte à permettre l'injection d'un flux laminaire de gaz de purge par l'embouchure annulaire et l'écoulement dudit flux dans ledit passage annulaire jusqu'à l'ouverture du système d'évacuation des gaz.

Selon un mode de réalisation, la pièce additionnelle comprend une deuxième paroi opposée à la première paroi et présentant une forme concave définissant un logement adapté pour recevoir au moins en partie le support de substrat.

Selon un mode de réalisation, le support de substrat est mobile en translation dans la chambre de réaction vers une position dite de chargement dans laquelle ledit support est logé au moins en partie dans ledit logement de la pièce additionnelle.

De manière avantageuse, le dispositif comprend en outre une pluralité d'ailettes portées par la paroi latérale et faisant saillie dans le passage annulaire.

De manière particulièrement avantageuse, lesdites ailettes sont orientées de sorte à guider le flux de gaz de purge le long de la paroi latérale.

De préférence, la paroi latérale de la chambre de réaction et la première paroi de la pièce additionnelle sont parallèles dans une portion du canal d'injection présentant une longueur jusqu'à l'embouchure supérieure ou égale à 1 cm.

De préférence, la longueur de la portion du canal dans laquelle la paroi latérale de la chambre de réaction et la première paroi de la pièce additionnelle sont parallèles est dimensionnée pour injecter un flux laminaire de gaz de purge pour une vitesse d'écoulement dudit gaz comprise entre 0,35 m/s et 0,55 m/s. Le dispositif de réacteur pour dépôt chimique en phase vapeur selon l'invention comprend une chambre de réaction présentant une paroi latérale, un support de substrat présentant une surface périphérique, le support de substrat étant disposé dans la chambre de réaction de manière à former un passage annulaire entre la surface périphérique du support de substrat et la paroi latérale de la chambre de réaction, une pièce additionnelle et un injecteur de gaz de purge débouchant dans la chambre de réaction. La pièce additionnelle, une fois montée dans le dispositif de réacteur, forme une partie au moins d'une embouchure annulaire de l'injecteur.

De manière particulièrement avantageuse, ladite pièce est agencée pour former, une fois montée dans le dispositif de réacteur, une paroi additionnelle, la paroi latérale de la chambre de réaction et ladite paroi additionnelle délimitant un canal débouchant dans la chambre de réaction par l'embouchure annulaire, la paroi latérale et la paroi additionnelle étant parallèles dans une portion du canal comprenant l'embouchure.

Selon une forme d'exécution, ladite pièce présente une symétrie de révolution.

Un autre objet de l'invention concerne un procédé de dépôt chimique en phase vapeur sur un substrat supporté par un support de substrat, ledit support de substrat étant agencé dans une chambre de réaction présentant une paroi intérieure latérale de sorte à former un passage annulaire entre la surface périphérique du support de substrat et la paroi intérieure latérale de la chambre de réaction,
- l'injection d'un gaz réactif vers le substrat au travers d'un espace de travail ;
- l'injection d'un gaz de purge sous la forme d'un flux laminaire s'écoulant le long de la paroi intérieure latérale jusqu'au passage annulaire,
- l'évacuation du gaz réactif et du gaz de purge au travers d'une ouverture agencée dans la paroi intérieure latérale de la chambre de réaction, ladite ouverture étant agencée en aval dudit passage annulaire et en regard de l'espace de travail.

### BREVE DESCRIPTION DES DESSINS

D'autres caractéristiques, détails et avantages de l'invention apparaîtront à la lecture de la description détaillée ci-après, et des dessins annexés, sur lesquels :
- la figure 1 montre une vue en coupe axiale d'un réacteur selon l'invention ;
- la figure 2 montre une vue du détail II de la figure 1 ;
- la figure 3 montre une vue en perspective d'une partie d'un anneau d'évacuation de gaz du réacteur des figures 1 et 2 ;
- la figure 4 montre une vue en perspective d'une partie d'un anneau d'évacuation de gaz complémentaire de celle de la figure 3 ; et
- la figure 5 montre une partie en coupe axiale de l'anneau d'évacuation formé par l'assemblage des parties des figures 3 et 4.

Les dessins annexés comprennent des éléments de caractère certain. Ils pourront donc, non seulement servir à compléter l'invention, mais aussi contribuer à sa définition, le cas échéant.

### DESCRIPTION DETAILLEE DE MODES DE REALISATION DE L'INVENTION

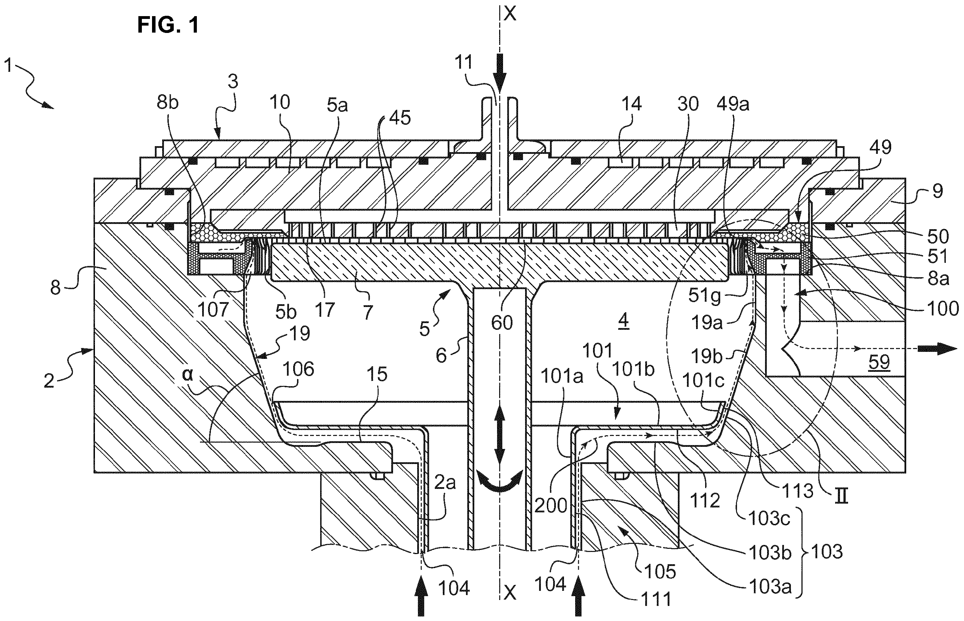

Les figures montrent un dispositif de traitement, ou réacteur référencé 1 dans son ensemble. De manière générale, le dispositif de traitement 1 présente une symétrie de révolution selon un axe central XX. Ceci favorise l'homogénéité des réactions chimiques et facilite la fabrication. Cette symétrie peut présenter quelques exceptions. Sur les dessins, cet axe est vertical, ce qui correspond à la disposition habituelle du dispositif en fonctionnement. Dans la suite, les termes haut, bas, horizontal et vertical sont utilisés conformément à la représentation en figures 1, 2 et 5. Le réacteur 1 est à pression et température contrôlées. Le réacteur 1 comprend un corps creux 2 et un couvercle 3 fermant le corps 2 pour former une chambre de réaction 4. La chambre de réaction 4 peut aussi être appelée enceinte. La chambre 4 loge un support 5, ou suscepteur, pour des substrats. Le réacteur 1 est conçu pour permettre l'injection dans la chambre 4 d'au moins un gaz réactif depuis une partie supérieure de la chambre 4 et celle d'un gaz de purge depuis une partie basse de la chambre 4. La chambre de réaction 4 délimite un environnement de réaction et ses parois guident les flux de gaz en présence pour favoriser les réactions seulement en certaines zones d'une part et pour évacuer les gaz mélangés d'autre part.

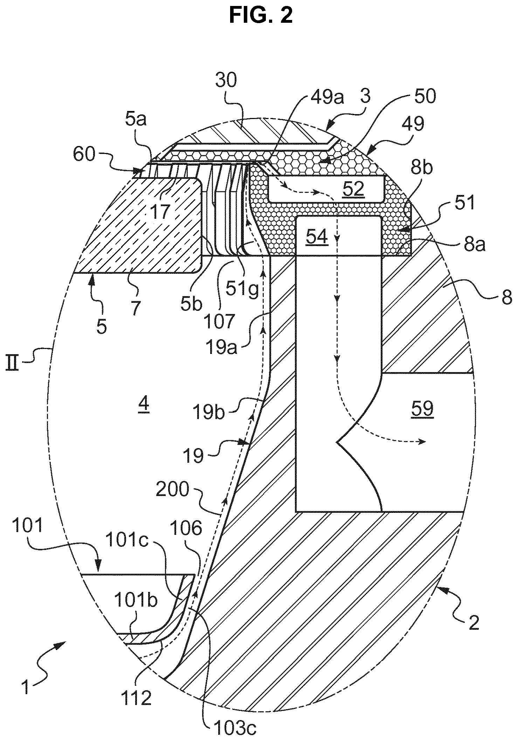

La chambre 4 est délimitée par une paroi intérieure inférieure 15, une paroi intérieure supérieure 17 et une paroi intérieure latérale 19 qui relie la paroi inférieure 15 à la paroi supérieure 17. Ici, la paroi inférieure 15 et la paroi supérieure 17 présentent chacune une forme générale de disque, tandis que la paroi latérale 19 présente une forme générale de révolution et relie le bord périphérique de la paroi inférieure 15 à la périphérie de la paroi supérieure 17. Dans l'exemple des figures 1 et 2, la paroi inférieure 15 présente un diamètre inférieur à celui de la paroi supérieure 17. En conséquence, la paroi latérale 19 comprend une portion haute 19a sensiblement cylindrique et une portion basse 19b sensiblement tronconique reliées l'une à l'autre. La portion basse 19b s'évase en direction de la paroi supérieure 17.

La paroi latérale 19 est reliée à la paroi supérieure 15 et à la paroi inférieure 17 par des congés de raccordement.

Le support 5 comprend ici un plateau 7 et un pied 6 allongé. Le plateau 7 présente une face principale inférieure fixée à une extrémité supérieure du pied 6. Dans l'exemple décrit ici, le pied 6 et le plateau 7 du support 5 sont venus de matière. Le pied 6 traverse une ouverture 2a du corps 2 au travers de la paroi inférieure 15. Le support 5 est monté mobile en translation par rapport à la chambre 4. Le support 5 peut être déplacé entre une position haute, dite de travail, dans laquelle le plateau 7 est proche de la paroi supérieure 17 et une position basse, dite de chargement, dans laquelle le plateau 7 est éloigné de la paroi supérieure 17. Sur les figures 1 et 2, le support 5 se trouve en position de travail. Dans cette position, le plateau 7 est à une distance verticale de la paroi supérieure 17, inférieure à 20 millimètres et de préférence supérieure à 5 millimètres.

Le plateau 7 peut être monté à rotation par rapport à la chambre 4 et tourner selon l'axe vertical XX du pied 6. La vitesse de rotation est fonction de la vitesse recherchée d'écoulement des gaz sur le support 5, de la taille du substrat, et de la vitesse de dépôt requise/souhaitée.

Le plateau 7 présente une face principale supérieure 5a opposée à la face inférieure et destinée à supporter un ou plusieurs substrats à traiter. La face principale supérieure 5a est disposée en regard de la paroi supérieure 17. Le plateau 7 présente une surface périphérique 5b qui relie la face principale 5a à la face inférieure. La surface périphérique 5b s'étend sensiblement au droit de la face principale supérieure 5a et sur l'épaisseur du plateau 7.

Le support 5 peut être muni d'un organe de régulation thermique, non représenté, par exemple du type décrit dans la demande de brevet publiée sous le numéro EP 0 619 381 déposée au nom de Applied Materials Inc., le 31 mars 1994. L'organe de régulation thermique est sélectivement utilisé pour chauffer et/ou refroidir. L'organe de régulation thermique est utilisé ici pour ajuster la température des substrats en fonction des réactions chimiques voulues.

En position de travail, la distance séparant la paroi supérieure 17 de la face principale supérieure 5a est faible. Ceci limite l'effet d'un gradient de convection vertical, dû à un écart de température entre la paroi supérieure 17 et la face principale 5a.

La surface périphérique 5b et la portion de la paroi latérale 19 correspondante, la portion haute 19a en position de travail, présentent une symétrie de révolution. En position de travail, la surface périphérique 5b et la portion de la paroi latérale 19 correspondante sont concentriques et en vis-à-vis l'une de l'autre. En variante, la paroi latérale 19 et la surface périphérique 5b peuvent suivre une périphérie de forme autre que circulaire, par exemple carrée, rectangulaire, ou encore ovale.

Le plateau 7 présente une forme générale de disque. Le support 5 et en particulier le plateau 7 est réalisé en un matériau thermiquement conducteur supportant des températures supérieures à 800°C. Les matériaux utilisés permettent de maintenir l'intégrité du support 5 dans des ambiances hautement réductrices comme c'est le cas en présence de dihydrogène et d'ammoniac. Le support 5 est réalisé en un matériau qui présente en outre une faible inertie thermique pour lui permettre de rapidement monter et descendre en température durant les différentes phases d'utilisation

Le support 5 est, ici, réalisé en nitrure d'aluminium (AIN). En variante, il peut être réalisé en graphite et revêtu d'une couche de carbure de silicium, en sorte que le support 5 présente une résistance accrue aux environnements chimiques.

Dans une variante non représentée, un fluide caloporteur est mis en circulation dans des conduits ménagés à cet effet dans le corps 2.

Le refroidissement des parois inférieure 15 et latérale 19 délimitant la chambre 4 réduit les dépôts parasites de surface. Le temps nécessaire au nettoyage de la chambre 4 s'en trouve réduit, augmentant ainsi la productivité du réacteur 1.

Après avoir posé un substrat sur le support 5, on ferme le couvercle 3 de manière étanche. En variante, l'introduction et le retrait des substrats sur le support 5 peuvent être réalisés via une chambre de transfert sous vide, éventuellement munie d'un robot.

Le couvercle 3 comprend une partie principale 10, dans laquelle sont ménagées une première entrée de gaz 11 formant une source de gaz réactif pour le réacteur 1 et des moyens de régulation thermique dudit gaz. Le couvercle 3 comprend une partie externe 9 reposant sur le corps 2 et supportant la partie principale 10. La partie externe 9 du couvercle 3 présente une forme générale de couronne reposant sur une surface supérieure d'une partie principale 8 en partie haute du corps 2. Le couvercle 3 comprend un disque d'injection 30 formant partie au moins de la paroi supérieure 17 de la chambre 4 et fixé à la partie principale 10, par exemple par vissage. Le disque d'injection 30 loge en outre une partie d'un système d'injection de gaz réactif provenant de la première entrée 11.

La partie principale 8 du corps 2 est réalisée en un alliage métallique. De manière générale, la plupart des composants logés au moins partiellement à l'intérieur de la chambre 4 peuvent être réalisés en aluminium ou en un alliage d'aluminium présentant peu de dégazage à haute température.

La partie principale 10 du couvercle 3 prend une forme générale de disque. La partie principale 10 peut être réalisée en alliage léger, ici de l'aluminium. La partie principale 10 est conductrice thermiquement et percée d'un trou central reliant fluidiquement la première entrée de gaz 11 du réacteur 1 au système d'injection de gaz réactif du disque d'injection 30.

Le système d'injection de gaz réactif logé dans le disque d'injection 30 comprend des moyens de régulation thermique du gaz réactif. Les moyens de régulation thermique du gaz réactif comprennent ici un élément de chauffage 14 qui inclut une pièce annulaire renfermant un fluide caloporteur mis en circulation dans un circuit de refroidissement/chauffage. Un tel système d'injection de gaz et un tel système de régulation thermique sont par exemple décrits dans la demande de brevet français publiée sous le numéro FR 2 930 561 et déposée le 28 avril 2008 au nom de la Demanderesse.

Le disque d'injection 30 est maintenu axialement entre une surface inférieure de la partie principale 10 du couvercle 3 et un anneau d'évacuation des gaz 49 du réacteur 1. Le disque d'injection 30 forme une grande partie, centrale, de la paroi supérieure 17 de la chambre 4. L'espace séparant le disque d'injection 30 du support de substrat 5 peut être vu comme un espace de travail 60 s'étendant entre la surface supérieure principale 5a du support 5 et la paroi supérieure 17 de la chambre 4. L'espace de travail 60 est le lieu de réaction souhaité entre le gaz réactif et les substrats et/ou entre les gaz réactifs.

Le disque d'injection 30 loge des canaux 45 mettant en communication fluidique le trou central de la partie principale 10 et la chambre 4. Les canaux 45 s'étendent au travers du disque d'injection 30 sensiblement verticalement. Les canaux 45 débouchent en la paroi supérieure 17, dans l'espace de travail 60 de la chambre 4. Les canaux 45 sont répartis régulièrement dans le disque d'injection 30 tandis que leurs embouchures sont réparties régulièrement en la surface de la chambre 4 portée par la paroi supérieure 17. L'entrée 11 du couvercle 3, le trou central de la partie principale 10 et les canaux 45 du disque d'injection 30 forment ensemble, de l'amont vers l'aval, une alimentation en gaz réactif pour la chambre 4.

Dans le mode de réalisation décrit ici, une alimentation en gaz supplémentaire, pour un second gaz réactif, est prévue. Le disque d'injection 30 est pourvu d'une pluralité de canaux supplémentaires formant une partie de l'alimentation en gaz réactif supplémentaire. Les canaux supplémentaires débouchent dans l'espace de travail 60 de la chambre 4 entre la surface principale supérieure 5a et la paroi supérieure 17. Les canaux supplémentaires sont alimentés depuis une seconde entrée de gaz du réacteur 1 sensiblement similaire et distincte de la première entrée 11. L'alimentation en gaz supplémentaire n'est pas représentée.

L'élément chauffant 14 permet de maintenir le ou les gaz de réaction, en amont de la chambre 4, à une température à laquelle ces derniers sont stables chimiquement, par exemple une température supérieure à leur température de rosée pour éviter les phénomènes de condensation. Par ailleurs, le disque d'injection 30 peut être réalisé en un matériau à haute conductivité thermique, par exemple à base d'alliage léger d'aluminium (Al), ce qui permet de réguler la température du disque d'injection 30 par contact avec la partie principale 10 du couvercle 3 et conduction thermique. La température du disque d'injection 30 est choisie pour limiter les réactions parasites des réactifs gazeux à l'affleurement du disque d'injection 30.

Le gaz réactif pénètre dans le réacteur 1 par l'entrée 11 du couvercle 3. En aval de l'entrée 11, le gaz réactif pénètre dans la chambre de réaction 4 par les embouchures des canaux 45. Les canaux 45 forment une arrivée de gaz réactif dans la chambre de réaction 4.

Un anneau d'évacuation des gaz 49 est monté sur une surface annulaire 8a de la partie principale 8 du corps 2 sensiblement horizontale et est entouré d'une surface cylindrique 8b du corps 2 formant un alésage. L'anneau 49 est, dans l'exemple décrit ici, une pièce rapportée dans le corps 2. En variante, l'anneau 49 peut être solidaire, voire monobloc, du corps 2. L'anneau d'évacuation des gaz 49 peut également être en contact avec une partie périphérique d'une surface inférieure du disque d'injection 30.

Dans la position de travail représentée en figure 2, l'anneau 49 entoure l'espace de travail 60. L'anneau 49 est aussi disposé au moins partiellement autour du plateau 7 du support 5. Comme cela est visible en figures 1 et 2, une partie de l'anneau 49 forme une partie de la paroi latérale 19, et une autre partie de l'anneau 49 forme une partie de la paroi supérieure 17. La conformation mutuelle de l'anneau 49 et du support 5 est telle que, dans une position de travail, le support 5 est disposé en partie dans l'anneau 49 et un passage 107 est formé entre la surface périphérique 5b du support 5 et une partie de la paroi latérale 19 appartenant ici à l'anneau 49. Le passage 107 prend ici la forme d'un canal annulaire périphérique en partie haute de la chambre 4. La distance horizontale entre la paroi latérale 19 et le support 5, c'est-à-dire ici entre l'anneau 49 et la surface périphérique 5b, est ici comprise entre 10 et 30 millimètres.

Les canaux 45 d'injection de gaz de la paroi supérieure 17, la surface principale supérieure 5a et l'anneau d'évacuation des gaz 49 sont disposés de façon qu'un flux de gaz réactif s'écoule depuis les canaux d'injection 45 jusqu'à l'anneau d'évacuation des gaz 49 en passant par l'espace de travail 60. Les gaz réactifs sont introduits par l'entrée 11 du réacteur 1, au travers du disque d'injection 30, et s'écoulent dans l'espace de travail 60 à l'affleurement de la surface principale supérieure 5a. Les précurseurs non consommés poursuivent leur trajet vers l'anneau 49 selon des directions sensiblement radiales du centre vers la périphérie du plateau 7 du support 5.

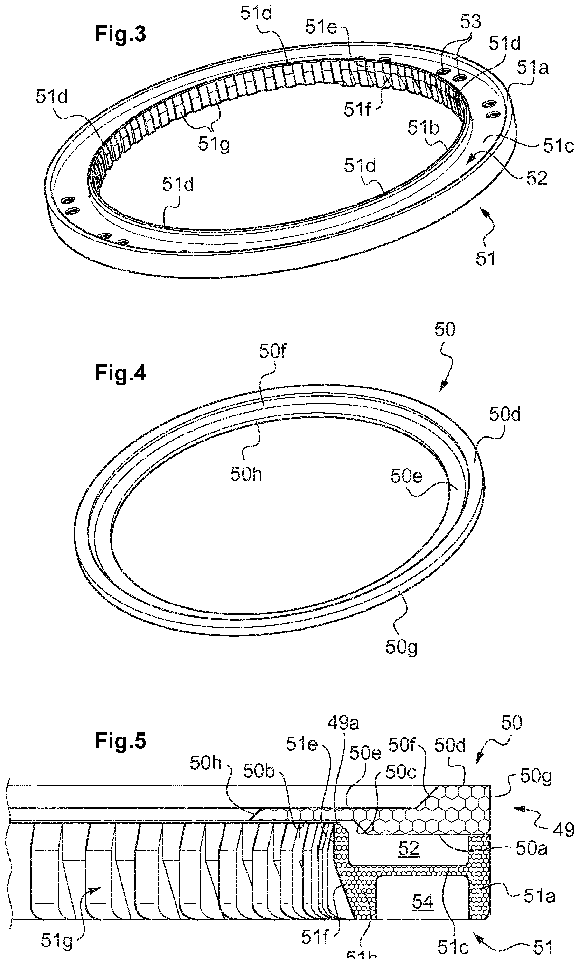

Dans l'exemple décrit ici, l'anneau 49 prend la forme d'un assemblage de plusieurs pièces. L'anneau 49 comprend une partie supérieure 50 représentée isolée sur la figure 4 et une partie inférieure 51 isolée sur la figure 3. Les sections longitudinales selon un demi-plan comprenant l'axe de révolution de la partie supérieure 50 et de la partie inférieure 51 dans un état assemblé sont visibles en figure 5.

La partie supérieure 50 prend la forme d'une pièce annulaire de section sensiblement régulière sur sa circonférence. La partie supérieure 50 comprend une surface inférieure (non visible sur la figure 4). La surface inférieure inclut, ici, une surface inférieure radialement extérieure 50a et une surface inférieure radialement intérieure 50b reliées entre elles par une surface inférieure tronconique 50c. La surface inférieure radialement extérieure 50a et la surface inférieure radialement intérieure 50b sont généralement planes et parallèles entre elles. La surface inférieure radialement intérieure 50b est décalée vers le haut, c'est-à-dire vers le disque d'injection 30 à l'état monté, par rapport à la surface inférieure radialement extérieure 50a de sorte que la surface inférieure tronconique 50c soit orientée vers le centre de la chambre 4.

La partie supérieure 50 comprend une surface supérieure. La surface supérieure inclut ici une surface supérieure radialement extérieure 50d et une surface supérieure radialement intérieure 50e reliées entre elles par une surface supérieure tronconique 50f. La surface supérieure radialement extérieure 50d et la surface supérieure radialement intérieure 50e sont planes et parallèles entre elles. La surface supérieure radialement intérieure 50e est décalée vers le bas, c'est-à-dire vers la partie inférieure 51 à l'état assemblé par rapport à la surface supérieure radialement extérieure 50d de sorte que la surface supérieure tronconique 50f est orientée vers le centre du disque d'injection 30.

L'épaisseur de la partie supérieure 50 selon la direction verticale est plus élevée au droit de la surface supérieure radialement extérieure 50d qu'au droit de la surface supérieure radialement intérieure 50e. La partie supérieure 50 comprend également une surface extérieure 50g sensiblement cylindrique en correspondance de forme avec l'alésage 8b du corps 2 et une surface intérieure 50h de faible dimension axiale, ici légèrement tronconique. La surface extérieure 50g s'ajuste à l'alésage 8b du corps 2 pour pouvoir y être insérée. La surface supérieure radialement intérieure 50e, la surface supérieure tronconique 50f et la surface intérieure 50h sont en correspondance de forme avec la périphérie du disque d'injection 30. Les formes et dimensions de l'anneau 49 permettent un ajustement de celui-ci à la fois avec le disque d'injection 30 et dans l'alésage 8b. La surface supérieure radialement extérieure 50d est en contact avec une surface inférieure de la partie principale 10. À l'état monté de l'anneau 49 dans le corps 2, la surface inférieure intérieure 50b et la surface inférieure du disque d'injection 30 sont sensiblement alignées et quasi-continues. Une portion interne de la partie supérieure 50 portant la surface inférieure radialement intérieure 50b forme une partie, périphérique, de la paroi supérieure 17. La portion interne de la partie intérieure 50 et le disque d'injection 30 forment ensemble une partie au moins de la paroi supérieure 17 de la chambre 4.

La partie supérieure 50 sert d'entretoise entre la partie principale 10 du couvercle 3 et la partie inférieure 51 de l'anneau 49. La partie supérieure 50 de l'anneau d'évacuation de gaz 49 est réalisée en un matériau supportant des variations rapides de températures sans détérioration, par exemple ici de l'aluminium.

Comme cela est mieux visible en figure 5, la partie inférieure 51 présente une forme générale annulaire à section transversale en forme de "H". La partie inférieure 51 comprend une paroi extérieure 51a, une paroi intérieure 51b et une paroi de liaison 51c reliant la paroi extérieure 51a à la paroi intérieure 51b. La paroi extérieure 51a et la paroi intérieure 51b sont de forme générale cylindrique. La paroi intérieure 51b présente une hauteur strictement inférieure à la distance verticale séparant la surface inférieure radialement intérieure 50b de la partie supérieure 50 et la surface annulaire 8a du corps 2 à l'état assemblé. Ainsi, une ouverture ou un interstice 49a circonférentiel est formé entre la partie supérieure 50 et la paroi intérieure 51b de la partie inférieure 51. Dans la variante où l'anneau 49 est réalisé d'une seule pièce au lieu d'un assemblage de pièces, l'interstice 49a est alors ménagé dans ladite pièce.

La paroi de liaison 51c est disposée entre un tiers et deux tiers de la hauteur de la paroi extérieure 51a, par exemple ici sensiblement à la moitié de celle-ci. À l'état installé, la paroi extérieure 51a et la paroi intérieure 51b sont sensiblement verticales tandis que la paroi de liaison 51c est sensiblement horizontale. Lorsque l'anneau 49 est disposé dans le corps 2, la paroi intérieure 51b forme une partie de la paroi latérale 19.

Un canal annulaire inférieur 54 est formé entre la paroi intérieure 51a, la paroi extérieure 51b, la paroi de liaison 51c et la surface annulaire 8a du corps 2. Un canal annulaire supérieur 52 est formé entre la paroi extérieure 51a, la paroi intérieure 51b, la paroi de liaison 51c et la surface inférieure radialement extérieure 50a de la partie supérieure 50, cf. figure 5. La paroi de liaison 51c est percée d'une pluralité de trous de communication 53. Les trous 53 mettent en communication le canal supérieur 52 et le canal inférieur 54. Le canal inférieur 54 est en communication avec un canal de pompage 59 ménagé dans le corps 8 et une sortie d'évacuation de gaz du réacteur 1. Les trous 53 et le canal de pompage 59 sont des exceptions à la symétrie de révolution du réacteur 1.

L'ensemble comprenant, de l'amont vers l'aval, le canal supérieur 52, les trous 53, le canal inférieur 54 et le canal de pompage 59 forme un canal d'évacuation de gaz 100. L'interstice 49a appartient à la fois à la chambre de réaction 4 et au canal d'évacuation de gaz 100. L'interstice 49a forme alors une sortie de gaz de la chambre 4 et une entrée de gaz pour le canal d'évacuation des gaz 100.

L'interstice 49a forme un espace circonférentiel dans l'anneau d'évacuation des gaz 49 s'ouvrant autour de l'espace de travail 60. L'interstice 49a met en communication fluidique la chambre 4 du côté intérieur de la paroi intérieure 51b et le canal d'évacuation des gaz 100. L'ouverture circonférentielle 49a ménagée dans la paroi latérale 19 relie fluidiquement le passage 107 au canal supérieur 52 pour évacuer des gaz depuis la chambre de réaction 4 vers l'extérieur du réacteur 1.

La surface supérieure de la paroi intérieure 51b comprend des plots 51d en saillie vers la partie supérieure 50, cf. figure 3. Les plots 51d ont une hauteur sensiblement égale à la hauteur de l'interstice 49a. Les plots 51d sont en contact avec la surface inférieure radialement intérieure 50b de la partie supérieure 50. Dans un état assemblé, les plots 51d de la partie inférieure 51 forment des portions d'appui de la partie supérieure 50 de l'anneau 49. Les plots 51d maintiennent la partie supérieure 50 et la partie inférieure 51 à distance l'une de l'autre pour former l'interstice 49a. Les plots 51d sont régulièrement répartis sur la circonférence et forment des interruptions de l'interstice 49a sur de faibles portions angulaires par rapport à la circonférence totale de l'anneau 49. Les plots 51d forment des exceptions à la symétrie de révolution de l'anneau 49. Bien que l'interstice 49a soit formé d'une succession de parties ouvertes et de plots 51d, l'interstice 49a est considéré comme continu du point de vue de la circulation des gaz.

Une ouverture angulaire de l'interstice 49a sur la circonférence totale ou presque de l'anneau 49 permet une évacuation avec aspiration de gaz homogène et à écoulement laminaire dans la gamme de débit envisagée. Il peut être mis en oeuvre, par exemple, un débit inférieur à 10 slm sous une pression comprise entre 200 et 300 Torr, soit 10 litres par minute sous condition de température standard (environ 20°C) et sous 266 à 400 hPa.

Les gaz réactifs proviennent des canaux 45 et sont évacués par l'interstice 49a disposé à la périphérie de l'espace de travail 60 de la chambre 4 et à proximité au-dessus du passage 107. Cela permet de régulariser les lignes d'écoulement de fluide dans la chambre 4. En fonctionnement, un flux de gaz réactif circule dans l'espace de travail 60 de la chambre 4, des canaux 45 à l'interstice 49a. L'interstice 49a entre la partie supérieure 50 et la partie inférieure 51 de l'anneau 49 présente une hauteur maximale comprise entre 0,5 et 2 millimètres.

La paroi intérieure 51b, dont la surface intérieure définit en partie la chambre 4, forme une partie de la paroi latérale 19 et définit ici le passage 107. La paroi intérieure 51b porte ici du côté intérieur une surface cylindrique supérieure 51e au-dessus de la paroi de liaison 51c et une surface tronconique inférieure 51f, dans la continuité de la surface cylindrique 51e, sous la paroi de liaison 51c, et orientée vers le centre de la chambre 4. En variante, la surface intérieure de l'anneau 49 peut comprendre une surface tronconique inférieure et une surface tronconique supérieure. L'angle d'inclinaison de la surface tronconique inférieure est supérieur à celui de la surface tronconique supérieure.

Le réacteur 1 comprend une pièce additionnelle 101. La pièce additionnelle 101 prend la forme générale d'une pièce de révolution ou de pièce tubulaire au diamètre variant selon un axe de révolution.

Successivement et du bas vers le haut à l'état monté dans la chambre 4, la pièce additionnelle 101 comprend une portion cylindrique 101a, une portion d'épaulement 101b et une portion tronconique 101c. La pièce additionnelle présente une première paroi comprenant des surfaces 111, 112, 113 respectives des portions 101a, 101b, 101c agencées en vis-à-vis de la paroi inférieure 15 et de la portion basse 19b de la paroi latérale de la chambre de réaction. Ladite première paroi de la pièce additionnelle 101 présente des formes et des dimensions correspondant aux formes et aux dimensions d'une partie inférieure de la chambre 4 et de l'ouverture 2a du corps 2. La pièce additionnelle 101 est disposée en partie dans la chambre 4 et en partie dans l'ouverture 2a, sous le support de substrat 5 et à distance de l'anneau 49 d'évacuation des gaz. En position de travail, le plateau 7 est à distance de la pièce additionnelle 101. La position de la pièce additionnelle 101 est, ici, la même en position de travail qu'en position de chargement.

Le diamètre extérieur de la portion cylindrique 101a est strictement inférieur au diamètre intérieur de l'alésage de l'ouverture 2a du corps 2 de sorte que la portion cylindrique 101a puisse être insérée dans l'ouverture 2a, sans contact avec la surface de l'ouverture 2a. La portion cylindrique 101a est alignée et centrée dans l'ouverture 2a. Le pied 6 du support 5 est disposé à l'intérieur du cylindre formé par la portion cylindrique 101a. Un espace annulaire est préservé entre la surface extérieure de la portion cylindrique 101a et l'alésage de l'ouverture 2a. La portion cylindrique 101a est fixée par son extrémité inférieure au reste de la chambre 4 (non représenté sur les figures). La portion cylindrique 101a est ici une portion de fixation de la pièce rapportée dans la chambre de réaction 4.

La portion d'épaulement 101b prend la forme d'une couronne s'étendant sensiblement perpendiculairement et vers l'extérieur de la portion cylindrique 101a. La portion d'épaulement 101b est reliée solidairement à l'extrémité haute de la portion cylindrique 101a. La portion d'épaulement 101b forme une paroi radiale plane et d'épaisseur sensiblement égale à celle de la paroi de la portion cylindrique 101a. Le diamètre intérieur de la portion d'épaulement 101b correspond au diamètre de la portion cylindrique 101a. Le diamètre extérieur de la portion d'épaulement 101b est strictement inférieur au diamètre de la paroi inférieure 15 de la chambre 4. La portion d'épaulement 101b est disposée sensiblement parallèle et au-dessus de la paroi inférieure 15 de la chambre 4. La portion d'épaulement 101b est sans contact avec la paroi inférieure 15. Un espace est préservé entre la paroi inférieure 15 de la chambre 4 et la surface 112 de la première paroi dans la portion d'épaulement 101b.

La portion tronconique 101c s'étend vers le haut en s'éloignant de l'axe de révolution depuis la périphérie de la portion d'épaulement 101b. La portion tronconique 101c est reliée à la portion d'épaulement 101b. La portion tronconique 101c est d'épaisseur sensiblement égale à celle de la portion cylindrique 101a et de la portion d'épaulement 101b. La conicité de la portion cylindrique 101a est sensiblement égale à celle de la portion basse 19b de la paroi latérale 19. Une partie au moins de la portion basse 19b est en vis-à-vis de la surface 113 de la première paroi dans la portion tronconique 101c, cette partie formant une seconde portion de la paroi latérale 19. Le rayon extérieur de la portion tronconique 101c augmente de manière homogène selon une progression verticale dirigée vers le haut, de sorte que la paroi de la portion tronconique 101c soit droite sur une vue en coupe telle que sur les figures 1 et 2. Le rayon extérieur de chaque section de la portion tronconique 101c est strictement inférieur au diamètre intérieur de la section de la seconde portion de la paroi latérale 19 qui est en vis-à-vis. La portion tronconique 101c est disposée concentriquement à la paroi latérale 19 de la chambre 4. La portion tronconique 101c est sans contact avec la paroi latérale 19. Un espace est préservé entre la paroi latérale 19 de la chambre 4 et la surface 113 de la première paroi dans la portion tronconique 101c. La portion tronconique 101c s'étend sur une hauteur, dans la direction verticale, de préférence supérieure à 10 millimètres, par exemple ici 15 millimètres. La position et la hauteur de la portion tronconique 101c sont telles que la pièce additionnelle 101 n'entrave pas la descente du plateau 7 pour atteindre une position de chargement.

Dans l'exemple décrit ici, le support 5 et la pièce additionnelle 101 sont mutuellement conformés et agencés de manière que le support 5 puisse être translaté dans la chambre 4 vers une position où il est entouré par la pièce additionnelle 101, par exemple en position de chargement. Le diamètre de la surface périphérique 5b est inférieur au diamètre intérieur d'une partie au moins de la portion tronconique 101c. La pièce additionnelle 101 présente une deuxième paroi opposée à la première paroi et orientée vers le support 5, ladite deuxième paroi présentant une forme concave formant un logement de la surface périphérique 5b dans la position de chargement du support 5.

La pièce additionnelle 101 est disposée dans une partie basse de la chambre 4, les espaces annulaires entre la première paroi de la pièce additionnelle 101 formée des surfaces 111, 112, 113 et les surfaces de la chambre 4 formant des tronçons d'un canal 103 de forme annulaire. Un premier tronçon 103a défini entre la portion cylindrique 101a et l'alésage 2a est de forme sensiblement cylindrique. Un second tronçon 103b défini entre la portion d'épaulement 101b et la paroi inférieure 15 est de forme sensiblement en couronne. Un troisième tronçon 103c défini entre la portion tronconique 101c et la seconde portion de la paroi latérale 19 est de forme sensiblement tronconique. La forme et les dimensions de la pièce additionnelle 101 sont fonction de la configuration de la chambre 4 pour que le canal 103 présente une section la plus régulière possible. La forme et les dimensions de la première paroi de la pièce additionnelle 101 sont fonction de la chambre 4 de sorte qu'un écoulement le plus laminaire possible du flux de gaz de purge 200 dans le canal 103 soit privilégié.

En particulier, pour favoriser un tel écoulement laminaire, on fait en sorte que la paroi latérale 19 de la chambre de réaction et la première paroi de la pièce additionnelle 101 soient parallèles dans le troisième tronçon 103c jusqu'à l'embouchure 106 du conduit dans la chambre 4. A cet égard, la paroi latérale 19 de la chambre de réaction et la première paroi de la pièce additionnelle 101 sont parallèles sur une longueur supérieure ou égale à 1 cm jusqu'à l'embouchure 106. De manière avantageuse, la longueur de la portion du canal dans laquelle la paroi latérale 19 de la chambre de réaction et la première paroi de la pièce additionnelle 101 sont parallèles est dimensionnée pour injecter un flux laminaire de gaz de purge pour une vitesse d'écoulement dudit gaz comprise entre 0,35 m/s et 0,55 m/s.

La surface radialement extérieure de la pièce additionnelle 101 forme des surfaces de guidage 111, 112, 113. Le canal 103 suit la forme des surfaces de guidage 111, 112, 113 et la forme du bas de la chambre 4. Le canal 103 présente donc un diamètre variant en fonction de la section de la pièce additionnelle 101 et de la section de la chambre 4 qui le délimitent. Autrement dit, le diamètre du canal 103 est supérieur à celui de la section de la pièce additionnelle 101 qui le délimite et inférieur à celui de la section de la chambre 4 qui le délimite. La paroi latérale 19 et la première paroi de la pièce additionnelle 101 délimitent ensemble le canal 103 et en particulier le troisième tronçon 103c.

L'extrémité libre de la partie tronconique 101c et la partie de la paroi latérale 19 qui en est la plus proche définissent une embouchure 106. Autrement dit, le canal 103 se termine par l'embouchure 106. Le canal 103 débouche dans la chambre 4 par l'intermédiaire de l'embouchure 106.

Un injecteur de gaz de purge 105 comprend, de l'amont vers l'aval, une seconde entrée de gaz 104 du réacteur 1, le canal 103 et l'embouchure 106. Le canal 103 s'ouvre sur la chambre de réaction 4 par l'embouchure 106. Au fond de la chambre 4 et de l'ouverture 2a est ménagée la seconde entrée ou arrivée de gaz 104 destinée à former la source d'un gaz de purge pour le réacteur 1. L'entrée 104 permet d'injecter un gaz de purge, par exemple à base d'azote (N) ou d'Argon (Ar), depuis le fond de la chambre 4. La seconde entrée 104 débouche dans le bas du premier tronçon 103a du canal 103. Autrement dit, la seconde entrée 104 est en amont du canal 103, lui-même en amont de l'embouchure 106. Lorsque la pièce additionnelle 101 est montée dans la chambre 4, le canal 103 défini entre la première paroi de la pièce additionnelle 101 et la paroi latérale 19 forme une prolongation de l'injecteur de gaz 105. Le canal 103 est agencé pour diriger un flux de gaz de purge 200 parallèlement à la paroi latérale 19. L'injecteur de gaz de purge 105 débouche dans la chambre de réaction 4. La seconde entrée de gaz 104 forme une entrée pour du gaz de purge dans le réacteur 1 tandis que l'embouchure 106 forme une entrée pour du gaz de purge dans la chambre 4.

L'écoulement laminaire du gaz de purge le long de la paroi latérale et dans le passage 107 empêche les gaz réactifs provenant de l'espace de travail 60 de pénétrer dans l'espace inférieur de la chambre de réaction 4. Le flux de gaz de purge 200, laminaire lors de sa traversée du passage 107, crée une surpression et entraîne les gaz de réaction vers l'anneau d'évacuation des gaz 49.

La Demanderesse a constaté que la disponibilité d'un équipement de dépôt chimique en phase vapeur équipé d'un tel système de gaz de purge est au moins deux fois plus importante que lorsque le flux de gaz de purge 200 est turbulent. Il est donc possible de réduire la fréquence des nettoyages de la chambre de réaction 4 sans pour autant nuire à la qualité des couches déposés.

Par ailleurs, le débit de gaz de purge nécessaire lorsque l'écoulement est turbulent est supérieur à celui d'un écoulement laminaire pour une efficacité donnée, autres paramètres étant semblables par ailleurs. À titre d'exemple, lors d'un dépôt en phase vapeur de silicium amorphe ou polycristallin, le débit du flux de gaz de purge 200 est d'environ 5 litres par minute, alors qu'il est supérieur à 10 litres par minute en présence de turbulences (sous conditions standard de température).

Dans les systèmes existants, le gaz de purge tend à diluer en partie les gaz réactifs dans l'espace supérieur. La diminution du débit des gaz réactifs limite encore la contamination de la chambre de réaction 4. À titre d'exemple, la Demanderesse a pu réduire le débit de gaz réactif (du silane par exemple) dans une chambre de réaction présentant un système de purge selon l'invention à 20 sccm alors qu'en présence d'un système classique, le débit devrait être d'environ 50 sccm, soit 20 millilitres par minute au lieu de 50 millilitres par minute (sous conditions standard de température).

La réduction du débit de gaz de purge initie un cercle vertueux et plusieurs avantages : la concentration en gaz réactif dans l'espace supérieur est augmentée, le rendement des réactions chimiques souhaitées est augmenté, le gaspillage et donc la consommation de gaz réactif peuvent être réduits. La réduction de consommation des espèces consommables génère une réduction des coûts.

Sur les figures, une pièce accessoire est rapportée et montée dans le réacteur pour former la pièce additionnelle 101. La forme de la pièce accessoire, ici une pièce de révolution creuse, est adaptée au réacteur de l'exemple. Dans des variantes, la pièce additionnelle 101 peut être solidaire, voire monobloc, d'autres composants du réacteur 1. Conformer une pièce accessoire en vue de la rapporter dans un réacteur permet de faciliter la fabrication et même d'équiper des réacteurs préexistants. En outre, la deuxième paroi de la pièce additionnelle est l'une des surfaces de la chambre de réaction la plus susceptible de donner lieu à des dépôts inopportuns ; le fait que ladite pièce soit amovible permet de la nettoyer plus facilement et éventuellement de la remplacer par une pièce propre, ce qui minimise le temps d'immobilisation du réacteur. Dans des variantes, les formes de la pièce additionnelle 101 diffèrent de celles décrites ici en fonction des formes de la chambre de réaction 4.

Dans l'exemple décrit ici la pièce additionnelle 101 est réalisée d'un seul tenant par déformation plastique d'un tronçon de tube en aluminium (Al). En variante, la pièce additionnelle 101 est réalisée par assemblage de plusieurs pièces. La pièce additionnelle 101 peut être réalisée par moulage et en tout autre matériau présentant des caractéristiques mécaniques et de résistance à la corrosion, comparables. De manière préférée, la pièce additionnelle 101 présente des profils homothétiques ou forme une pièce de révolution. Cela permet de simplifier sa fabrication et d'éviter des erreurs de montage dans une chambre 4.

Le flux de gaz de purge 200 s'écoule du bas vers le haut dans le canal 103. Depuis l'entrée 104, le gaz de purge remonte dans le premier tronçon 103a, dans le second tronçon 103b, dans le troisième tronçon 103c et sort du canal 103 à l'extrémité haute de la portion tronconique 101c au travers de l'embouchure 106 pour émerger dans la chambre 4. Au niveau de l'embouchure 106, la portion tronconique 101c est à une distance de la paroi latérale 19 inférieure à 10 millimètres, et de préférence comprise entre 4 et 8 millimètres. Une portion terminale du canal 103 est sensiblement parallèle à la portion de la paroi latérale 19 immédiatement en aval de l'embouchure 106. Le canal 103 est agencé pour diriger le flux de gaz de purge 200 parallèlement à la paroi latérale 19 au moins sur une partie de celle-ci à proximité de l'embouchure 106.

Durant la phase de travail, le flux de gaz de purge 200 est guidé depuis le canal 103, entre la seconde portion de la paroi latérale 19 et la surface 113 de la pièce additionnelle 101, de manière qu'une partie au moins du flux de gaz 200 aboutisse dans le passage 107. Le canal 103 et le passage 107 sont disposés sensiblement dans le prolongement l'un de l'autre de sorte qu'un gaz injecté depuis l'entrée 104, s'écoulant le long du canal 103 et débouchant dans la chambre 4 par l'embouchure 106 le long de la paroi latérale 19, s'écoule sensiblement selon un régime laminaire le long de la paroi latérale 19. Le gaz de purge remonte alors le long de la paroi latérale 19 de la chambre 4 jusqu'au passage 107.

L'embouchure 106 et le passage 107 présentent chacun une forme annulaire. Cette identité de forme améliore le comportement laminaire de l'écoulement de gaz entre l'embouchure 106 et le passage 107. Bien que la forme du canal 103 en amont de l'embouchure 106 permette d'améliorer encore l'orientation du flux de gaz de purge 200, l'identité de forme entre l'embouchure 106 et le passage 107 permet à elle seule d'améliorer le comportement laminaire du flux de gaz de purge 200.

La paroi latérale 19 est avantageusement agencée pour supporter un flux laminaire de gaz de purge le long de ladite paroi au moins de l'embouchure 106 au passage 107. Comme cela est visible sur les figures 1 et 2 en position du travail, le flux de gaz 200 est dépourvu de support physique du côté diamétralement intérieur du réacteur 1. La paroi latérale 19 est suffisante pour guider le flux de gaz de purge 200. Le flux de gaz 200 sortant du canal 103 par l'embouchure 106 parallèlement à la paroi latérale 19 à une vitesse choisie présente une épaisseur correspondant à l'embouchure 106. La vitesse étant non nulle, une dépression est engendrée entre le flux de gaz 200 et la paroi latérale 19. La paroi latérale 19 attire le flux de gaz 200 et le guide entre l'embouchure 106 et le passage 107. La paroi latérale 19, du côté diamétralement extérieur, supporte le gaz ascendant entre l'embouchure 106 et le passage 107. La paroi latérale 19 peut présenter une forme droite, légèrement concave ou légèrement convexe selon la direction d'écoulement, tout en continuant de guider le flux de gaz en l'absence de surface correspondante en regard.

La portion haute 19a et la portion basse 19b de la paroi latérale 19 forment, ici, un léger changement de direction (une forme légèrement concave) pour l'écoulement gazeux sans pour autant que cela nuise au comportement laminaire du flux. Au contraire, la Demanderesse a constaté qu'un changement de direction d'un angle compris entre 10° et 30° limite le risque de créer un régime turbulent. Comme cela est visible sur les figures, le changement de direction correspond à un angle droit auquel on retranche α (90° - alpha). L'angle α (alpha) entre la portion basse 19b et un plan horizontal paroi est compris entre 60 et 80°.

L'affleurement de l'embouchure 106 avec la paroi latérale 19 améliore le comportement laminaire du flux en aval de l'embouchure 106. La paroi latérale 19 forme une prolongation du pourtour de l'embouchure 106 qui est à même de dévier le flux de gaz 200 pour lui faire suivre la direction de la paroi latérale 19 jusqu'au passage 107.

Le gaz de purge atteint le passage 107, entre la première portion de la paroi latérale 19, ici la paroi intérieure 51b de l'anneau 49, et la surface périphérique 5b du support 5. Le passage 107 est conformé pour guider le flux de gaz de purge 200 en provenance du canal 103 de manière qu'une partie au moins du flux de gaz 200 passe par l'ouverture circonférentielle 49a.

En passant le long de la surface cylindrique supérieure 51e et de la surface cylindrique inférieure 51f de la paroi intérieure 51b de l'anneau 49, le flux de gaz de purge 200 augmente l'échange thermique entre l'anneau 49 et l'intérieur de la chambre 4. Le flux de gaz de purge 200 participe au refroidissement de l'anneau 49 qui a tendance à s'échauffer au contact, direct ou indirect, avec des éléments chauffants.

Comme cela est visible en figure 3 de l'exemple décrit ici, la paroi latérale 19 porte des ailettes 51g. Les ailettes 51g sont semblables les unes aux autres. Les ailettes 51g font saillie depuis la surface intérieure de l'anneau 49 en direction du centre de l'anneau 49. À l'état installé de l'anneau 49 dans le corps 2, les ailettes 51g font saillie dans le passage 107. Les ailettes 51g sont de forme sensiblement allongée selon la direction verticale et sur la hauteur de la paroi intérieure 51b. Les ailettes 51g font saillie depuis la paroi latérale 19 d'au moins 1millimètre, de préférence au moins 5 millimètres. La dimension en saillie des ailettes 51g n'est pas prise en compte pour le calcul de l'écart entre le support de substrat 5 et la paroi latérale 19. Néanmoins, des extrémités horizontales des ailettes 51g sont à distance de la surface périphérique 5b. Les extrémités verticales des ailettes 51g sont reliées aux extrémités verticales de la paroi intérieure 51b par des congés de raccordement. Les ailettes 51g se répartissent de manière régulière sur la circonférence de l'anneau 49, ici sur la paroi intérieure 51b. La surface périphérique 5b étant en regard des ailettes 51g, les ailettes 51g se répartissent ici régulièrement autour du plateau 7.

Comme cela est visible sur les figures 3 et 5, l'épaisseur des ailettes 51g est sensiblement égale à leur écartement mutuel. La distance séparant deux ailettes 51g adjacentes l'une de l'autre est égale à l'épaisseur d'une desdites ailettes 51g. Dans une vue en coupe selon un plan perpendiculaire à l'axe de révolution de l'anneau 49, les ailettes 51g présentent un profil rectangulaire. Autrement dit, à la courbure de l'anneau 49 près, la succession des ailettes 51g forme une succession de créneaux en une répétition de motifs. Les créneaux, ainsi que les trous 53 et les plots 51d forment des exceptions à la symétrie de révolution de l'anneau 49.

Dans l'exemple décrit ici, les ailettes 51g sont ménagées dans la paroi intérieure 51b de la pièce rapportée que forme l'anneau 49. Cela facilite la fabrication. En variante, les ailettes 51g sont ménagées dans la paroi latérale 19.

De manière générale, les formes et dimensions des ailettes 51g sont telles que la surface intérieure de l'anneau 49 munie des ailettes 51g présente une surface de contact dans la chambre 4 (ici avec les gaz dans la chambre 4) importante. L'une des fonctions des ailettes 51g est celle d'ailettes d'échangeur de chaleur. Une telle surface de contact améliore les échanges thermiques entre l'anneau 49 et l'intérieure de la chambre 4. Les formes et dimensions des ailettes 51g sont en outre choisies de sorte qu'un contact entre le support 5 et l'anneau 49 soit évité. Les ailettes 51g confèrent à la paroi intérieure 51b de l'anneau 49, et donc à la paroi latérale 19, une surface libre supérieure à celle d'une configuration semblable mais dépourvue d'ailette. En fonctionnement, l'anneau 49 est maintenu à une température inférieure à celle d'un anneau similaire dépourvu d'ailette de refroidissement. Les ailettes 51g permettent par exemple de maintenir la température de l'anneau 49 en dessous de 300°C. Une telle température limite le ramollissement de l'anneau 49 et les dépôts parasites sur des surfaces de l'anneau 49.

Cette régulation de la température permet de limiter les réactions parasites des gaz de réaction qui entrent en contact avec l'anneau 49 et avec la paroi latérale 19. Les dépôts solides résultant de telles réactions sont limités.

Le refroidissement de l'anneau 49, grâce aux ailettes 51g, est d'autant plus efficace qu'un flux de gaz de purge 200 circule à leur contact. Cela est d'autant plus efficace grâce à la pièce additionnelle 101 qui permet de générer un flux laminaire de gaz de purge s'écoulant entre l'embouchure 106 et le passage 107. Les passages entre les ailettes 51g sont empruntés par le gaz de purge qui s'écoule à distance de l'espace de travail 60. Le flux de gaz de purge est d'effet quasi neutre sur la dynamique des gaz dans l'espace de travail 60. Le flux de gaz de purge étant laminaire, son temps de résidence dans la chambre 4 est minimisé par rapport à celui d'un flux turbulent, ce qui augmente l'efficacité des échanges thermiques.

La présence des ailettes 51g tend à réduire la section de passage du passage 107 et à limiter la migration des gaz réactifs vers l'espace inférieur.

Les formes et les dimensions des ailettes 51g décrites ici sont un exemple de réalisation. D'autres formes et dimensions peuvent être envisagées. En variante, les ailettes 51g peuvent présenter une épaisseur dans la direction de la circonférence différente de l'écartement mutuel des ailettes. Les ailettes peuvent par exemple présenter un profil triangulaire, en "dents de scie", arrondi ou en dôme.

Dans le cas où un flux de gaz, par exemple un flux de gaz de purge 200, s'écoule contre la paroi intérieure 51b, contre la paroi latérale 19, les ailettes 51g peuvent en outre être avantageusement agencées pour guider le flux de gaz traversant le passage 107. Dans ce cas, les ailettes 51g améliorent encore les propriétés laminaires de l'écoulement gazeux. Le flux de gaz est mieux guidé entre chaque ailette 51g tout en restant supporté par la paroi latérale 19. Ici, les ailettes 51g sont au contact du flux de gaz de purge 200 et orientées parallèlement à ce dernier (verticales).

En variantes, les ailettes 51g sont disposées allongées selon une direction différente de la verticale, par exemple selon une direction légèrement hélicoïdale à l'image d'un filetage intérieur de l'anneau 49.

Dans le mode de réalisation représenté sur les figures, les ailettes 51g sont disposées sur la paroi intérieure 51b de l'anneau 49. L'échange thermique entre les ailettes 51g et la chambre 4 survient à proximité immédiate du canal d'évacuation de gaz 100 pour réguler la température des surfaces intérieures dudit canal d'évacuation des gaz 100. Les ailettes 51g sont réparties à l'écart du flux de gaz réactif pour éviter que des dépôts parasites ne s'y produisent. En variante, les ailettes 51g peuvent être disposées en des emplacements de la paroi latérale 19 différents de la paroi intérieure 51b.

Comme cela est représenté sur les figures 1 et 2, le flux de gaz de purge 200 entraîne le flux de précurseurs gazeux vers l'anneau 49 au travers de l'ouverture circonférentielle 49a. On évite ainsi que des gaz réactifs s'écoulent sous le support 5 et se déposent, c'est-à-dire y forment des dépôts. Le flux de gaz de purge 200 autour du support de substrat 5 empêche les réactifs de descendre dans la chambre de réaction 4. Le flux de gaz de purge 200 et le flux de gaz réactif mêlés sont évacués par l'intermédiaire de l'ouverture circonférentielle 49a, du canal supérieur 52, des trous 53, du canal inférieur 54 de l'anneau 49 et par le canal de purge 59, autrement dit par le canal d'évacuation de gaz 100.

Les gaz de réaction s'écoulent sur le substrat et la surface principale supérieure 5a du support 5 jusqu'à l'anneau 49. Le flux gazeux est essentiellement parallèle aux surfaces du substrat et du support 5 et présente un régime laminaire. On garantit ainsi une épaisseur uniforme de dépôt pour tous les substrats s'appuyant sur le support 5.

Le réacteur 1 peut ainsi mettre en oeuvre des températures adaptées aux gaz utilisés pour les nouvelles générations de dispositifs réalisés sur des substrats, notamment des solutions vaporisées de précurseurs solides ou bien des gaz présentant une tendance à la condensation ou au dépôt de résidus solides. De hautes températures peuvent être utilisées.

L'anneau d'évacuation des gaz 49 tend à être échauffé indirectement par conduction thermique des autres éléments chauffants et par convexion au contact des gaz réactifs chauds. Afin de limiter les réactions parasites des gaz dans le circuit d'évacuation, qui pourraient conduire à des obturations, l'anneau d'évacuation des gaz 49 est maintenu à une température inférieure à la température de réaction des gaz.

On vient de décrire un réacteur pour dépôt chimique en phase vapeur amélioré.

Le réacteur 1 est pourvu du passage 107 délimité par le support 5 et la paroi latérale 19, et de l'embouchure 106 de forme correspondante au passage 107 et en affleurement de la paroi latérale 19, tandis que la paroi latérale 19 est agencée pour supporter le flux de gaz de purge 200 au moins de l'embouchure 106 au passage 107. Cette configuration favorise le comportement laminaire des écoulements gazeux dans la chambre 4. Les dépôts deviennent plus homogènes et présentent une meilleure reproductibilité. Et les réactions parasites dans la chambre 4 sont réduites, en particulier sous le support 5.

La présence des ailettes 51g est optionnelle. Toutefois, les ailettes 51g améliorent également le caractère laminaire des écoulements gazeux en guidant le flux de gaz à l'intérieur du passage 107.

En outre, la présence d'ailettes 51g augmente les échanges thermiques entre la paroi latérale 19 et l'intérieur de la chambre 4. La température de la paroi latérale 19 se trouve régulée par conduction thermique. Cette régulation thermique limite les réactions parasites dans le canal d'évacuation de gaz 100.

Le réacteur 1 proposé est particulièrement avantageux lors d'utilisations mettant en oeuvre au moins deux réactifs gazeux susceptibles de réagir l'un avec l'autre. Cependant, le réacteur 1 reste utilisable avec un seul gaz réactif destiné à réagir au contact des substrats. Dans ce dernier cas, l'amélioration du comportement laminaire du flux de gaz de purge 200 tend à homogénéiser l'écoulement du flux de gaz réactif à l'affleurement des substrats, ce qui améliore l'homogénéité des processus chimiques souhaités et donc la qualité des produits obtenus. Les composantes circonférentielles des écoulements gazeux au sein de la chambre 4 sont réduits, qu'il s'agisse du gaz réactif, du gaz de purge ou d'un mélange de ceux-ci. La reproductibilité est améliorée.

## Revendications

1. Dispositif de réacteur (1) pour dépôt chimique en phase vapeur comprenant :
- une chambre de réaction (4) présentant une paroi intérieure latérale (19) ;
- un injecteur (30) de gaz réactif débouchant dans la chambre de réaction (4) ;
- un support de substrat (5) présentant :
- une face principale (5a) destinée à supporter au moins un substrat, agencée en regard de l'injecteur (30) de gaz réactif de sorte que ledit injecteur (30) et ladite face principale (5a) définissent entre eux un espace de travail (60), et
- une surface périphérique (5b),
- un système (49) d'évacuation des gaz en liaison fluidique avec la chambre de réaction (4) par une ouverture (49a) agencée dans la paroi latérale (19) de la chambre de réaction (4) en regard de l'espace de travail (60),
le support de substrat (5) étant disposé dans la chambre de réaction (4) de manière à former un passage annulaire (107) entre la surface périphérique (5b) du support de substrat (5) et la paroi latérale (19) de la chambre de réaction (4) ;
- un injecteur (105) de gaz de purge débouchant dans la chambre de réaction (4) ;
**caractérisé en ce que** l'injecteur (105) de gaz de purge comprend un canal d'injection (103) délimité par la paroi latérale (19) de la chambre et une première paroi d'une pièce additionnelle (101), ledit canal débouchant dans la chambre de réaction (4) par une embouchure (106) annulaire, la paroi latérale (19) de la chambre de réaction et la première paroi (113) de la pièce additionnelle (101) étant parallèles dans une portion (103c) dudit canal d'injection comprenant l'embouchure (106),
de sorte à permettre l'injection d'un flux laminaire de gaz de purge (200) par l'embouchure annulaire (106) et l'écoulement dudit flux dans ledit passage annulaire (107) jusqu'à l'ouverture (49a) du système d'évacuation des gaz.

2. Dispositif selon la revendication 1, dans lequel la pièce additionnelle (101) comprend une deuxième paroi opposée à la première paroi et présentant une forme concave définissant un logement adapté pour recevoir au moins en partie le support de substrat (5).

3. Dispositif selon la revendication 2, dans lequel le support de substrat (5) est mobile en translation dans la chambre de réaction (4) vers une position dite de chargement dans laquelle ledit support (5) est logé au moins en partie dans ledit logement de la pièce additionnelle (101).

4. Dispositif selon l'une des revendications 1 à 3, comprenant en outre une pluralité d'ailettes (51g), les ailettes (51g) étant portées par la paroi latérale (19) de la chambre de réaction, les ailettes (51g) faisant saillie dans le passage annulaire (107).

5. Dispositif selon la revendication 4, dans lequel les ailettes (51g) sont orientées de sorte à guider le flux de gaz de purge (200) le long de la paroi latérale (19).

6. Dispositif selon l'une des revendications 1 à 5, dans lequel la paroi latérale (19) de la chambre de réaction et la première paroi de la pièce additionnelle (101) sont parallèles dans une portion dudit canal d'injection présentant une longueur jusqu'à l'embouchure (106) supérieure ou égale à 1 cm.

7. Dispositif selon l'une des revendications 1 à 6, **caractérisée en ce que** la longueur de la portion canal (103c) dans laquelle la paroi latérale (19) de la chambre de réaction et la première paroi de la pièce additionnelle (101) sont parallèles est dimensionnée pour injecter un flux laminaire de gaz de purge pour une vitesse d'écoulement dudit gaz comprise entre 0,35 m/s et 0,55 m/s.

8. Procédé de dépôt chimique en phase vapeur sur un substrat supporté par un support de substrat (5), ledit support de substrat (5) étant agencé dans une chambre de réaction (4) présentant une paroi intérieure latérale (19) de sorte à former un passage annulaire (107) entre la surface périphérique (5b) du support de substrat (5) et la paroi intérieure latérale (19) de la chambre de réaction (4),
- l'injection d'un gaz réactif vers le substrat au travers d'un espace de travail (60) ;
- l'injection d'un gaz de purge sous la forme d'un flux laminaire (200) s'écoulant le long de la paroi intérieure latérale (19) jusqu'au passage annulaire (107),
- l'évacuation du gaz réactif et du gaz de purge au travers d'une ouverture (49a) agencée dans la paroi intérieure latérale (19) de la chambre de réaction (4), ladite ouverture (49a) étant agencée en aval dudit passage annulaire (107) et en regard de l'espace de travail (60).

## Patentansprüche

1. Reaktorvorrichtung (1) zur chemischen Aufbringung in der Dampfphase, umfassend:
- eine Reaktionskammer (4), die eine interne laterale Wand (19) aufweist;
- eine Einspritzdüse (30) für reaktives Gas, die in die Reaktionskammer (4) mündet;
- einen Substratträger (5), der aufweist:
- eine Hauptseite (5a), die zum Tragen wenigstens eines Substrats bestimmt und gegenüber der Einspritzdüse (30) für reaktives Gas derart angeordnet ist, dass die genannte Einspritzdüse (30) und die genannte Hauptseite (5a) untereinander einen Arbeitsraum (60) definieren und
- eine peripherische Oberfläche (5b),
- ein Austragssystem (49) in fluidischer Verbindung mit der Reaktionskammer (4) durch eine Öffnung (49a), die in der lateralen Wand (19) der Reaktionskammer (4) gegenüber dem Arbeitsraum (60) angeordnet ist,
wobei der Substratträger (5) in der Reaktionskammer (4) derart angeordnet ist, dass ein ringförmiger Durchgang (107) zwischen der peripherischen Oberfläche (5b) des Substratträgers (5) und der lateralen Wand (19) der Reaktionskammer (4) gebildet wird;
- eine Einspritzdüse (105) für Spülgas, die in die Reaktionskammer (4) mündet;
**dadurch gekennzeichnet, dass** die Einspritzdüse (105) für Spülgas einen Einspritzkanal (103) umfasst, der durch die laterale Wand (19) der Kammer und eine erste Wand eines zusätzlichen Stücks (101) begrenzt wird, wobei der genannte Kanal durch eine ringförmige Mündung (106) in die Reaktionskammer (4) mündet, wobei die laterale Wand (19) der Reaktionskammer und die erste Wand (113) des zusätzlichen Stücks (101) parallel in einem Abschnitt (103c) des genannten Einspritzkanals sind, der die Mündung (106) umfasst,
derart, dass das Einspritzen eines laminaren Stroms Spülgas (200) durch die ringförmige Mündung (106) und das Ablaufen des genannten Stroms in den genannten ringförmigen Durchgang (107) bis zur Öffnung (49a) des Austragssystems der Gase erlaubt wird.

2. Vorrichtung gemäß Anspruch 1, bei der das zusätzliche Stück (101) eine zweite Wand umfasst, die der ersten Wand gegenüberliegt und eine konkave Form aufweist, die eine Aufnahme aufweist, die geeignet ist, um den Substratträger (5) wenigstens zum Teil aufzunehmen.

3. Vorrichtung gemäß Anspruch 2, bei der der Substratträger (5) in der Reaktionskammer (4) zu einer als Ladeposition bezeichneten Position in Translation mobil ist, in der der genannte Träger (5) wenigstens zum Teil in der genannten Aufnahme des zusätzlichen Stücks (101) aufgenommen ist.

4. Vorrichtung gemäß einem der Ansprüche 1 bis 3, umfassend darüber hinaus eine Vielzahl von Flügeln (51g), wobei die Flügel (51g) von der lateralen Wand (19) der Reaktionskammer getragen werden, wobei die Flügel (51g) in dem ringförmigen Durchgang (107) hervorstehen.

5. Vorrichtung gemäß Anspruch 4, in der die Flügel (51g) derart angeordnet sind, dass der Strom des Spülgases (200) entlang der lateralen Wand (19) geführt wird.

6. Vorrichtung gemäß einem der Ansprüche 1 bis 5, in der die laterale Wand (19) der Reaktionskammer und die erste Wand des zusätzlichen Stücks (101) in einem Abschnitt des genannten Einspritzkanals parallel sind, der eine Länge bis zur Mündung (106) von größer als oder gleich 1 cm aufweist.

7. Vorrichtung gemäß einem der Ansprüche 1 bis 6, **dadurch gekennzeichnet, dass** die Länge des Kanalabschnitts (103c), in dem die laterale Wand (19) der Reaktionskammer und die erste Wand des zusätzlichen Stücks (101) parallel sind, bemessen ist, um einen laminaren Strom Spülgas für eine Ablaufgeschwindigkeit des genannten Gases einzuspritzen, das zwischen 0,35 m/Sek. Und 0,55 m/Sek. Inbegriffen ist.

8. Verfahren zur chemischen Aufbringung in der Dampfphase auf einem von einem Substratträger (5) getragenen Substrat, wobei der genannte Substratträger (5) in einer Reaktionskammer (4) angeordnet ist, die eine laterale interne Wand (19) derart aufweist, dass ein ringförmiger Durchgang (107) zwischen der peripherischen Oberfläche (5b) des Substratträgers (5) und der lateralen internen Wand (19) der Reaktionskammer (4) gebildet wird,
- Einspritzen eines reaktiven Gases zu dem Substrat durch einen Arbeitsraum (60);
- Einspritzen eines Spülgases in Form eines laminaren Stroms (200), der entlang der lateralen internen Wand (19) bis zum ringförmigen Durchgang (107) abläuft,
- Austragen des reaktiven Gases und des Spülgases durch eine Öffnung (49a), die in einer lateralen internen Wand (19) der Reaktionskammer (4) angeordnet ist, wobei die genannte Öffnung (49a) dem genannten ringförmigen Durchgang (107) und gegenüber dem Arbeitsraum (60) nachgeschaltet ist.

## Claims

1. A reactor device (1) for chemical vapor deposition comprising:
- a reaction chamber (4) having a side inner wall (19) ;
- a reactive gas injector (30) opening into the reaction chamber (4);
- a substrate support (5) having:
- a main face (5a) intended to support at least one substrate, arranged opposite the reactive gas injector (30) so that said injector (30) and said main face (5a) define a work space (60) between same, and
- a peripheral surface (5b),
- a system (49) for discharging gas in fluid communication with the reaction chamber (4) through an opening (49a) arranged in the side wall (19) of the reaction chamber (4) facing the work space (60),
with the substrate support (5) being positioned in the reaction chamber (4) so as to form an annular passage (107) between the peripheral surface (5b) of the substrate support (5) and the side wall (19) of the reaction chamber (4) ;
- a purge gas injector (105) opening into the reaction chamber (4);
**characterized in that** the purge gas injector (105) comprises an injection channel (103) defined by the side wall (19) of the chamber and a first wall of an additional room (101), with said channel opening into the reaction chamber (4) through an annular mouth (106), with the side wall (19) of the reaction chamber and the first wall (113) of the additional room (101) being mutually parallel in a portion (103c) of said injection channel comprising the mouth (106),
so as to enable the injection of a laminar flow of purge gas (200) through the annular opening (106) and the flowing of said flow in said annular passage (107) up to the opening (49a) of the gas discharge system.

2. A device according to claim 1, wherein the additional room (101) comprises a second wall opposite the first wall and having a concave shape which defines a housing adapted to at least partly receive of the substrate support (5).

3. A device according to claim 2, wherein the substrate support (5) is mobile in translation in the reaction chamber (4) towards a so-called loading position, wherein said support (5) is at least partly received in said housing of the additional room (101).

4. A device according to one of claims 1 to 3, further comprising a plurality of fins (51g), with the fins (51g) being carried by the side wall (19) of the reaction chamber, with the fins (51g) protruding into the annular passage (107).

5. A device according to claim 4, wherein the fins (51g) are so oriented as to guide the purge gas flow (200) along the side wall (19).

6. A device according to one of claims 1 to 5, wherein the side wall (19) of the reaction chamber and the first wall of the additional room (101) are mutually parallel in a portion of said injection channel having a length up to the mouth (106) greater than or equal to 1cm.

7. A device according to one of claims 1 to 6, **characterized in that** the length of the channel portion (103c), wherein the side wall (19) of the reaction chamber and the first wall of the additional room (101) are mutually parallel, is so dimensioned as to inject a laminar flow of purge gas with a flow rate of said gas ranging from 0.35m/s to 0.55m/s.

8. A method for a chemical vapor deposition on a substrate supported by a substrate support (5), with said substrate support (5) being arranged in a reaction chamber (4) having a side inner wall (19), so as to form an annular passage (107) between the peripheral surface (5b) of the substrate support (5) and the side inner wall (19) of the reaction chamber (4), consisting in:
- injecting a reactive gas to the substrate through a work space (60);
- injecting a purge gas in the form of a laminar flow (200) flowing along the inner side wall (19) up to the annular passage (107),
- discharging the reactive gas and the purge gas through an opening (49a) arranged in the side inner wall (19) of the reaction chamber (4), with said opening (49a) being arranged downstream of said annular passage (107) and opposite the work space (60).
